# EUROPÄISCHE PATENTSCHRIFT

(11) **EP 0 738 897 B1**
(45) Veröffentlichungstag und Bekanntmachung des Hinweises auf die Patenterteilung: **09.08.2000**
(21) Anmeldenummer: 95104449.4
(22) Anmeldetag: 25.03.1995
(51) Int. Cl.: G01R 33/34

(54) **HF-Empfangsspulenanordnung für NMR-Spektrometer**
HF reception coils device for NMR spectrometer
Dispositif de bobines de réception HF pour spectromètre RMN

(43) Veröffentlichungstag der Anmeldung: 23.10.1996
(73) Patentinhaber: Bruker AG, 8117 Fällanden (CH)
(72) Erfinder: Marek, Daniel, Dr., CH-5115 Möriken/AG (CH); Laukien, Frank, Dr., US-001773 Lincoln, MA (US); Schett, Oskar, Hr., CH-8610 Uster (CH)
(74) Vertreter: KOHLER SCHMID + PARTNER

(56) Entgegenhaltungen:
- EP-A- 0 453 834
- DE-A- 1 423 467
- DE-A- 1 813 205
- US-A- 4 549 136

## Beschreibung

Die Erfindung betrifft eine HF-Empfangsspulenanordnung für insbesondere hochauflösende Kernspinresonanz-Spektrometer mit mindestens einem ersten aus supraleitendem Material aufgebauten HF-Empfangsspulensystem zum Empfangen von Kernspinresonanzsignalen, das um eine normalerweise ungefähr auf Zimmertemperatur in einem homogenen Magnetfeld befindliche Probe angeordnet ist und das aus mindestens einer symmetrisch um die Probe angeordneten Einzelspule besteht, wobei das erste HF-Empfangsspulensystem zumindest teilweise auf eine weit unter Zimmertemperatur liegende kryogene Betriebstemperatur gekühlt ist, bei der sich das erste HF-Empfangsspulensystem in supraleitendem Zustand befindet.

Eine solche HF-Empfangsspulenanordnung ist beispielsweise bekannt aus der DE 40 13 111 C2 bzw. der EP 0 453 834 A1.

Derartige HF-Empfangsspulenanordnungen werden insbesondere für hochauflösende NMR-Spektrometer eingesetzt, bei denen hohe Anforderungen an das Signal-zu-Rausch-Verhältnis der Signaldetektion gestellt werden. Um die Empfindlichkeit der Empfangsspulenanordnung zu erhöhen, wird daher bei bekannten Vorrichtungen das HF-Empfangsspulensystem zumindest teilweise auf eine kryogene Temperatur weit unter der Zimmertemperatur gekühlt, wodurch die elektrische Hochfrequenz(HF)- Leitfähigkeit der Spulen erhöht und damit das Signal-zu-Rausch-Verhältnis verbessert wird, weil geringere Verluste im Resonator auftreten. Dadurch ergibt sich eine besonders hohe Güte der Resonatoranordnung, die wiederum zu einer besonders hohen Empfindlichkeit führt.

Neben der Güte des Resonatorsystems der Empfangseinrichtung, die im wesentlichen durch die elektrischen Verluste in den Spulen bestimmt wird, spielt auch der Füllfaktor, also die räumliche Ankoppelung der Spule an die Probe eine wesentliche Rolle für das resultierende Auflösungsvermögen des Spektrometers. Trotz des Vorhandenseins von Kühleinrichtungen für die Empfangsspulen, die eine Erhöhung der Güte des Resonatorsystems bewirken, kann zumindest bei Anordnungen mit nur einem HF-Empfangsspulensystem eine enge Ankopplung der Empfangsspulen an die Probe und damit ein hoher Füllfaktor durch indirekte Kühlmaßnahmen erreicht werden, wie sie in der DE 40 13 111 C2 beschrieben sind.

Um eine weitere Verbesserung der Resonatorgüte und damit der Auflösung der Anordnung zu erzielen, wurde in der eingangs zitierten Druckschrift zudem theoretisch vorgeschlagen, ein HF-Empfangsspulensystem aus supraleitendem Material zu verwenden. In der Praxis werden derartige supraleitendende HF-Empfangsspulensysteme bisher aber nicht realisiert, weil supraleitende Spulen einerseits sehr aufwendig und teuer in der Herstellung, andererseits für die Verwendung insbesondere in der hochauflösenden Spektroskopie sehr heikel sind, weil sie aufgrund der sehr hohen, magnetfeldabhängigen Suszeptibilität der bekannten supraleitenden Materialien die erforderliche hohe Homogenität des statischen Magnetfelds im Bereich der Probe äußerst nachteilig beeinflussen. Die Verschlechterung der Feldmomogenität im Meßzentrum der Apparatur führt aber wiederum zu einer Linienverbreiterung und damit zu einer relativen Peakwerterniedrigung des gemessenen Signals. Besonders bei schmalen Linien in der hochauflösenden Spektroskopie ist der Einfluß der Suszeptibilität der HF-Empfangsspulenanordnung besonders störend.

Die Möglichkeit einer Kompensation von Suszeptibilitäts-Inhomogenitäten bei normal-leitenden HF-Empfangsspulen wird in der DE-A 14 23 467 beschrieben.

Im Bereich einer Magnetfeldstärke von etwa 0,01T [100 Gauß] beträgt die Suszeptibilität eines idealen Supraleiters ca. -1. Bei höheren Feldstärken im Bereich von 1T [10⁵ Gauß] liegt die Suszeptibilität des supraleitenden Materials immer noch bei 10⁻³. Im Gegensatz dazu liegt in diesen Feldstärkebereichen die Suszeptibilität von Kupfer bei etwa 10⁻⁵. Eine supraleitende HF-Empfangsspule hat daher bei gleichen geometrischen Abmessungen aufgrund ihrer hohen Suszeptibilität einen um ca. zwei Größenordnungen stärkeren Störeinfluß auf die Feldhomogenität als eine normalleitende, resistive Spule.

Aufgabe der vorliegenden Erfindung ist es demgegenüber, eine HF-Empfangsspulenanordnung der eingangs beschriebenen Art vorzustellen, bei der einerseits die hohe erreichbare Güte der Resonatoranordnung aufgrund des theoretisch bereits vorgeschlagenen Einsatzes von supraleitendem Material mit hoher elektrischer HF-Leitfähigkeit ausgenutzt werden kann, wobei aber die für praktische Zwecke erheblichen Nachteile der Störeinflüsse aufgrund der hohen Suszeptibilität des supraleitenden Materials auf die Homogenität des statischen Magnetfelds im Bereich der Meßprobe und damit auf die Linienbreite der empfangenen NMR-Signale vermieden werden.

Erfindungsgemäß wird diese Aufgabe dadurch gelöst, daß mindestens ein zweites HF-Empfangsspulensystem vorgesehen ist, das vorzugsweise zum ersten HF-Empfangsspulensystem orthogonal ist, wobei das zweite HF-Empfangsspulensystem ebenfalls aus mindestens einer symmetrisch um die Probe angeordneten Einzelspule besteht, und wobei das erste und das zweite HF-Empfangsspulensystem unterschiedliche radiale Abstände von der Probe aufweisen, und daß das zweite innere HF-Empfangsspulensystem aus elektrisch resistivem Material aufgebaut ist, wobei die Materialien und die Geometrien der HF-Empfangsspulensysteme so gewählt sind, daß der von sämtlichen HF-Empfangsspulen der Anordnung resultierende Einfluß der Suszeptibilität der HF-Empfangsspulenanordnung bei der kryogenen Betriebstemperatur des supraleitenden HF-Empfangsspulensystems auf die Homogenität des Magnetfeldes im Bereich der Probe minimal ist.

Für NMR-Messungen an mehreren unterschiedlichen Kernarten sind an sich bereits HF-Empfangsspulenanordnungen mit mehr als einem HF-Empfangsspulensystem bekannt, wobei die HF-Empfangsspulensysteme orthogonal in bezug auf die empfangenen Magnetfelder angeordnet und damit HF-magnetisch entkoppelt sind. So gibt es schon Mehrspulenanordnungen für Multikern-Messungen mit zwei kombinierten Sende- und Empfangsspulensystemen, mit denen beispielsweise neben Protonen auch ¹³C-Kernsignale gemessen werden können. In anderen bekannten Anordnungen ist ein zweites Empfangsspulensystem zum Einlocken der Meßsignale auf die Deuterium-Linie vorgesehen. Bei diesen bekannten Mehrspulenanordnungen ist jedoch weder eine Kühlung der HF-Empfangsspulensystem auf kryogene Temperaturen noch die Verwendung von supraleitendem Material für die Spulen vorgesehen. Daher sind bei diesen bekannten Mehrspulenanordnungen auch nicht die oben beschriebenen Probleme des negativen Einflusses der hohen Suszeptibilität von supraleitenden Spulenmaterialien auf die Feldhomogenität im Bereich der Probe und damit eine wesentliche Verschlechterung des Auflösungsvermögens des NMR-Sprektrometers aufgetreten.

Den größten Einfluß auf die Homogenität des statischen Magnetfelds am Ort der Probe nimmt naturgemäß das räumlich am nächsten zur Probe angeordnete HF-Empfangsspulensystem. Daher weist bei einer besonders bevorzugten Ausführungsform der erfindungsgemäßen HF-Empfangsspulenanordnung zumindest das innere HF-Empfangsspulensystem eine solche Struktur auf, bei der die Gesamtsuszeptibiltät des Systems nach außen hin im Sinne einer Reduzierung der Suszeptibilitäts-Inhomogenitäten im Bereich der Probe außerhalb des HF-Empfangspulensystems kompensiert ist. Die Kompensation erfolgt also an Ort und Stelle durch entsprechende Wahl der Spulenmaterialien und eine entsprechende geometrische Anordnung derselben relativ zueinander. Da der Einfluß der von der Probe weiter entfernten äußeren HF-Empfangsspulensysteme jedenfalls bezüglich der durch ihre Suszeptibilität hervorgerufenen Homogenitätsstörungen am Probenort wesentlich geringer ist, können beispielsweise die äußeren Systeme ohne allzu große Linienverbreiterung und Auflösungsverluste auch ohne oder nur mit grober Suszeptibilitätskompensation bleiben. Zudem erzeugen die weiter außen angeordneten Spulensysteme, weil sie räumlich größere Ausdehnungen besitzen, langwelligere Störungen, die i.w. Magnetfeldgradienten niederer Ordnungen erzeugen, die durch die üblichen Shimsysteme leichter zu kompensieren sind als die kurzwelligeren Störungen von den innersten Spulen, die Magnetfeldgradienten höherer Ordnungen erzeugen.

Das innere HF-Empfangsspulensystem, das aus elektrisch resistivem Material aufgebaut ist, weist, wie oben diskutiert, eine wesentlich geringere Suszeptibilität als supraleitendes Material auf, sodaß auch die Maßnahmen zur Kompensation der Suszeptibilität einen geringeren Aufwand als bei einer supraleitenden Spule erfordern. Die Suszeptibilitätskompensation mit resistivem Material ist zudem technisch schon lange gelöst wie dargestellt in DE-1 423 467, sodaß hierbei auf bekannte Methoden zurückgegriffen werden kann. Die supraleitenden HF-Empfangsspulensysteme mit größerem radialen Abstand von der Probe können demgegenüber ohne Suszeptibilitätskompensation ausgeführt sein, da aufgrund ihrer größeren Entfernung auch ein geringerer Einfluß der Suszeptibilität auf die Homogenität am Probenort erfolgt. Der schlechtere Füllfaktor aufgrund der geringeren Ankopplung der äußeren HF-Empfangsspulensysteme kann durch die höhere Resonatorgüte aufgrund der hohen elektrischen HF-Leitfähigkeit des supraleitenden Materials ausgeglichen oder sogar überkompensiert werden.

Bei einer konkreten Ausführungsform einer solchen suszeptibilitätskompensierten Anordnung kann das innere HF-Empfangsspulensystem aus Kupferdraht aufgebaut sein, dessen Suszeptibilität nach außen durch eine Platinseele kompensiert ist.

Besonders bevorzugt ist auch eine Ausführungsform der erfindungsgemäßen HF-Empfangsspulenanordnung, bei der mindestens ein supraleitendes HF-Empfangsspulensystem vorgesehen ist, in welchem die Spulen aus einer auf ein Substrat aufgebrachten, in der Größenordnung weniger Mikrometer dünnen supraleitfähigen Schicht bestehen. Dadurch wird die Menge an eingesetztem supraleitfähigem Material erheblich reduziert, was zu einer sehr starken Verringerung des schädlichen Einflusses der Suszeptibilität des HF-Empfangsspulensystems auf die Feldhomogenität am Probenort und damit auf die Linienbreite und das Auflösungsvermögen des NMR-Spektrometers führt. Derartige dünne supraleitende Schichten mit Dichten zwischen ungefähr einem und etwa zehn Mikrometern, die im wesentlichen der HF-Eindringtiefe entsprechen, können beispielsweise bei Verwendung von Hochtemperatur-Supraleitungsmaterial mit Hilfe von bekannten Epitaxialtechniken auf das Substrat aufgebracht werden.

Insbesondere kann ein derartiges HF-Empfangsspulensystem auch als eine auf eine Trägerstruktur aufgedampfte Käfigresonatoranordnung ausgeführt sein.

Vor allem, wenn das schichtförmig aufgebaute supraleitende System das innere HF-Empfangsspulensystem bildet, kann durch die extrem geringe räumliche Ausdehnung der supraleitenden Schicht ein besonders hoher Füllfaktor wegen der extrem guten HF-Ankopplung des Spulensystems an die Probe erreicht werden.

Bei einer Weiterbildung dieser Ausführungsform kann das Substrat, auf das die elektrisch leitende Schicht aufgebracht ist, ein verlustarmes Dielektrikum mit einer bei tiefen Temperaturen hohen Wärmeleitfähigkeit sein. Insbesondere in Verbindung mit einer indirekten Kühlung des supraleitenden HF-Empfangsspulensystems kann das Substrat beispielsweise aus einem Saphir- oder Quarzröhrchen bestehen. Mit einer solchen Anordnung wird nicht nur eine erhebliche Reduktion der Ohm'schen Verluste im Empfangsspulensystem, sondern auch eine wesentliche Verringerung der kapazitiven Verluste im HF-Resonatorsystem (bestehend aus Empfängerspule und kapazitiver Abstimmung) erreicht.

Eine alternative Ausführungsform zeichnet sich dadurch aus, daß das Substrat zusammen mit einem damit in wärmeleitendem Kontakt stehenden Metallblock, insbesondere aus Kupfer oder Aluminium, eine gekühlte Plattform bildet. Damit steht eine besonders einfache Art der indirekten Kühlung zur Verfügung, die insbesondere dann vorteilhaft ist, wenn das betreffende Spulensystem im Vakuum angeordnet ist, weil die Anordnung sehr platzsparend ausgebildet werden kann. Die Wärmeableitung zum kryogenen Medium übernimmt dabei die gekühlte Plattform.

Bevorzugt sind Ausführungsformen der erfindungsgemäßen HF-Empfangsspulenanordnung, bei denen zumindest ein Teil der HF-Empfangsspulen indirekt gekühlt ist, da dies aus den oben erwähnten geometrischen Gründen im Vakuum technisch einfacher zu realisieren ist.

Bei anderen Ausführungsformen kann zumindest ein Teil der HF-Empfangsspulen direkt gekühlt sein, was eine effizientere Wärmeableitung von den Spulen ermöglicht.

Besonders vorteilhaft ist schließlich eine Ausführungsform, bei der die HF-Empfangsspulensysteme im Bereich um die Probe in einem Vakuum angeordnet sind. Damit läßt sich eine besonders einfache thermische Isolation der gekühlten Spulen gegenüber der auf Zimmertemperatur befindlichen Probe bewerkstelligen, wobei keine Doppelwandung , sondern lediglich eine einfache Wand eines Dewar-Gefäßes erforderlich ist, sodaß auch eine größere räumliche Nähe der HF-Empfangsspulensysteme zur Probe und damit ein besserer Füllfaktor der Resonatoranordnung erzielt wird.

Die Erfindung wird im folgenden anhand der in der Zeichnung und der zugehörigen Beschreibung dargestellten Ausführungsbeispiele näher beschrieben und erläutert. Die der Beschreibung und der Zeichnung zu entnehmenden Merkmale können bei Ausführungsformen der Erfindung einzeln, für sich oder zu mehreren in beliebigen Kombination Anwendung finden. Es zeigen:
- Fig. 1: eine schematische Schnittdarstellung einer Anordnung zweier erfindungsgemäßer HF-Empfangsspulensysteme mit direkter Kühlung von innen aufgrund des Durchflusses eines kryogenen Mediums; und
- Fig. 2: eine schematische räumliche Darstellung einer erfindungsgemäßen HF-Empfangsspulenanordnung, wobei im unteren Teil der Figur das äußere, im oberen Teil das von diesem umschlossene innere HF-Empfangsspulensystem dargestellt ist.

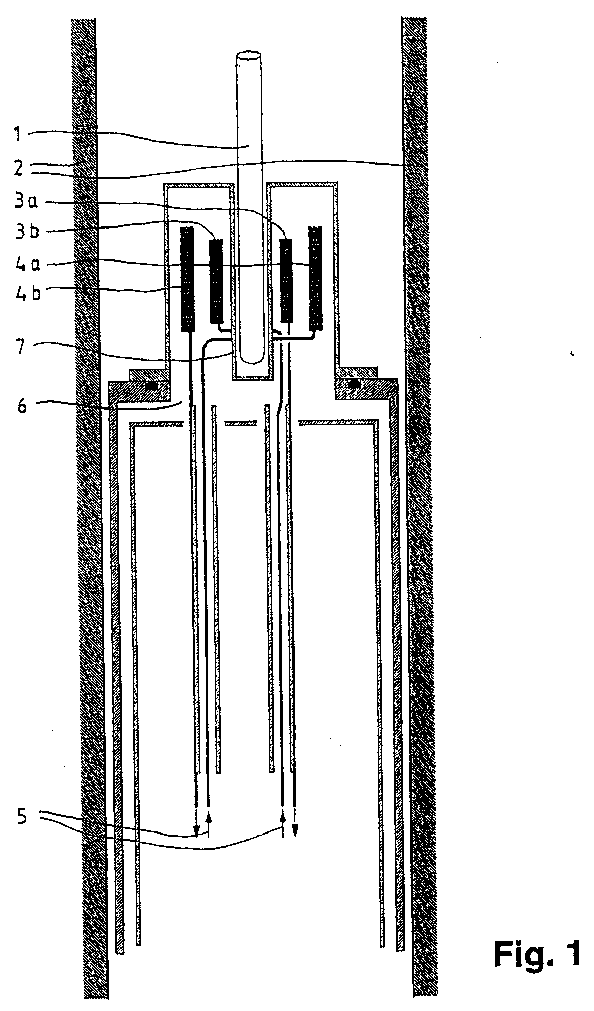

Bei der in **Fig. 1** gezeigten HF-Empfangsspulenanordnung, die insbesondere in hochauflösenden Kernspinresonanz-Spektrometern Verwendung findet, ist eine Probe 1 im homogenen Feld eines Magneten 2 von zwei im wesentlichen orthogonal zueinander angeordneten HF-Empfangsspulensysteme umgeben, die jeweils aus symmetrisch um die Probe 1 angeordneten Einzelspulen 3a, 3b bzw. 4a, 4b bestehen. Die HF-Empfangsspulensysteme 3a, 3b; 4a, 4b weisen unterschiedliche radiale Abstände von der Probe 1 auf, um eine orthogonale Anordnung räumlich zu ermöglichen.

Um möglichst geringe Ohm'sche Verluste und ein besonders gutes Signal-zu-Rausch-Verhältnis dieser Resonatoranordnungen zu erzielen, sind im dargestellten Beispiel beide HF-Empfangsspulensysteme in Form von gebogenen Röhrchen ausgeführt, die von einer kryogenen Flüssigkeit 5 durchströmt und somit von innen gekühlt werden. Bei anderen Ausführungsbeispielen kann die Kühlung auch auf indirekte Weise erfolgen oder auch nur auf einen Teil der Spulen beschränkt sein. Zumindest eines der HF-Empfangsspulensysteme 3a, 3b; 4a, 4b, möglicherweise aber auch beide Systeme sind aus einem supraleitenden Material aufgebaut, wobei des innere HF-Empfangsspulensystem 3a, 3b aus einem anderen Material als das äußere HF-Empfangsspulensystem 4a, 4b besteht. Die verwendeten Materialien weisen unterschiedliche, von der Betriebstemperatur abhängige physikalische Eigenschaften auf und sind in Verbindung mit der jeweiligen Geometrie der HF-Empfangsspulensysteme so gewählt, daß der von sämtlichen HF-Empfangsspulen der Anordnung resultierende Einfluß der Suszeptibilität der HF-Empfangsspulenanordnung bei der kryogenen Betriebstemperatur des supraleitenden HF-Empfangsspulensystems auf die Homogenität des Magnetfeldes im Bereich der Probe 1 minimal ist.

In der Regel wird die Suszeptibilitätskompensation an Ort und Stelle vorgenommen, d. h. die entsprechenden Spulen sind jeweils für sich nach außen hin suszeptibilitätskompensiert. Vorzugsweise wird zumindest eine Suszeptibilitätskompensation des inneren HF-Empfangsspulensystems 3a, 3b vorgenommen. Sowohl die resistiven als auch die supraleitenden HF-Empfangsspulensysteme der Anordnung können jeweils suszeptibilitätskompensiert sein. Es kann auch vorgesehen sein, daß sämtliche HF-Empfangsspulensysteme supraleitend sind. Zumindest wenn das innere HF-Empfangsspulensystem 3a, 3b supraleitend ist, sollte bei diesem eine Suszeptibilitätskompensation vorgesehen sein, da es räumlich der Probe 1 am nächsten ist und damit der negative Einfluß seiner Suszeptibilität auf die Homogenität des Magnetfeldes am Probenort besonders störend wirkt.

Vorteilhaft kann andererseits aber auch eine Hybridanordnung sein, bei der als inneres HF-Empfangsspulensystem 3a, 3b ein vorzugsweise suszeptibilitätskompensiertes resistives Spulensystem Anwendung findet, während bei dem äußeren HF-Empfangsspulensystem 4a, 4b keine oder nur eine grobe Suszeptibilitätskompensation erforderlich ist, was den Herstellungsaufwand und damit die Kosten der Apparatur erheblich verringern. Das suszeptibilitätskompensierte resistive innere HF-Empfangsspulensystem könnte beispielsweise in bekannter Manier aus suszeptibilitätskompensiertem Kupferdraht mit Platinseele aufgebaut sein.

Vorteilhafterweise sind die HF-Empfangsspulensysteme 3a, 3b; 4a, 4b in einem Vakuum 6 angeordnet, sodaß lediglich eine einzige Trennwand 7 zur thermischen Abkopplung gegenüber der normalerweise auf Zimmertemperatur befindlichen Probe 1 erforderlich ist, was eine wesentlich engere räumliche Annäherung des inneren HF-Empfangsspulensystems 3a, 3b an die Probe 1, folglich eine besonders gute HF-mäßige Ankopplung des Resonatorsystems und damit einen besonders höhen Füllfaktor ermöglicht.

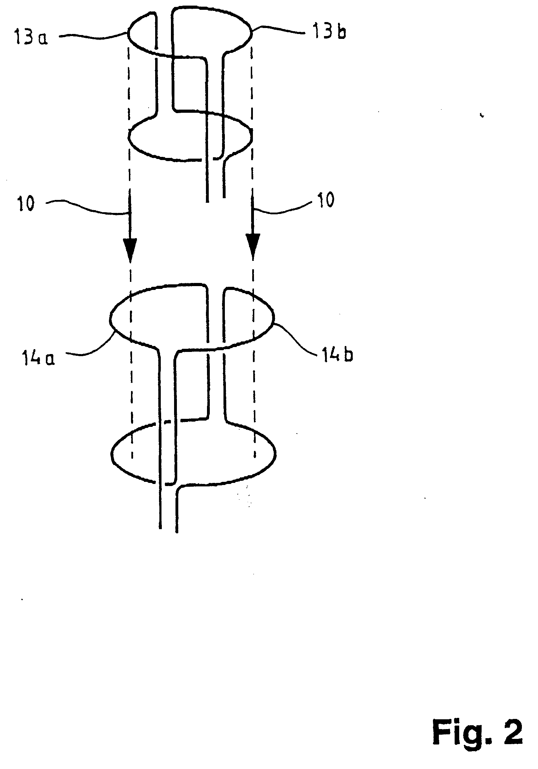

In **Fig. 2** ist eine erfindungsgemäße HF-Empfangsspulenanordnung in einer schematischen räumlichen Darstellung gezeigt. Dabei ist der Übersichtlichkeit halber das innere HF-Empfangsspulensystem 13a, 13b axial versetzt oberhalb des äußeren HF-Empfangsspulensystems 14a, 14b gezeichnet. Im Betriebszustand der Apparatur ist das innere HF-Empfangsspulensystem 13a, 13b in Richtung der Pfeile 10 in das äußere HF-Empfangsspulensystem 14a, 14b eingeschoben, wobei die beiden HF-Empfangsspulensysteme im wesentlichen orthogonal zueinander angeordnet sind, um eine maximale Entkoppelung der empfangenen NMR-Signale zu ermöglichen.

Bei der erfindungsgemäßen HF-Empfangsspulenanordnung können die HF-Empfangsspulen gleichzeitig auch als HF-Sendespulen verwendet werden, was den räumlichen Aufbau der gesamten Spulenanordnung erheblich vereinfacht und kompakter macht.

Das supraleitende HF-Empfangsspulensystem besteht vorzugsweise aus einer wenige Mikrometer dünnen supraleitfähigen Schicht, die auf ein Substrat, beispielsweise ein Saphir- oder Quarzröhrchen aufgebracht ist. Bei in der Zeichnung nicht dargestellten Ausführungsformen kann das Substrat in engem wärmeleitendem Kontakt mit einem Metallblock, insbesondere aus Kupfer oder Aluminium, stehen und mit diesem zusammen eine gekühlte Plattform bilden, mit der die supraleitende Schicht indirekt und in räumlich besonders kompakter Anordnung gekühlt wird.

Üblicherweise wird bei Verwendung von resistivem Kupferdraht bei HF-Empfangsspulenanordnungen eine Kompensation auf etwa 1% der Suszeptibilität des Kupfers vorgenommen. Da, wie oben erwähnt, die handelsüblichen supraleitenden Materialien selbst bei hohen Magnetfeldstärken bei kryogener Temperatur eine um zwei Größenordnungen höhere Suszeptibilität als Kupfer aufweisen, müßte bei einer bloßen Dickenkompensation folglich die supraleitende Spule gegenüber einer resistiven Spule ein um vier Größenordnungen geringeres Volumen aufweisen, um die gleiche Kompensationswirkung des schädlichen Einflusses der Suszeptibilität auf die Homogenität des Magnetfeldes am Probenort zu bewirken.

Übliche, für HF-Empfangsspulensysteme verwendete Drahtstärken liegen ungefähr bei 0,2 bis 0,3 mm. Demgegenüber ist bei Verwendung von supraleitenden dünnen Schichten in der Größenordnung von 0,005 mm der Störeinfluß der Suszeptibilität aufgrund der Volumenreduktion um etwa eine Größenordnung geringer. Anders ausgedrückt, genügt daher bei gleichem Einfluß der Suszeptibilität auf die Homogenität des Magnetfeldes am Probenort bei Verwendung einer dünnen Supraleiterschicht als HF-Empfangsspulensystem lediglich eine Suszeptibilitätskompensation auf 10% der Suszeptibilität von Kupfer, also um eine Größenordnung weniger als die übliche Kompensation von Kupferdraht auf etwa 1% der Suszeptibilität von Kupfer. Anders betrachtet, kann bei Verwendung der erwähnten dünnen Supraleiterschicht ganz auf eine Suszeptibilitätskompensation des supraleitenden HF-Empfangsspulensystems verzichtet werden, wobei lediglich bei ansonsten gleichen Konditionen gegenüber einer resistiven Anordnung der Einfluß der Suszeptibilität auf die Magnetfeldhomogenität am Probenort um etwa eine Größenordnung angehoben wird. Dies ist beispielsweise bei Messungen mit ohnehin breiteren NMR-Linien durchaus tolerabel, allerdings nicht bei Messungen in der hochauflösenden NMR.

## Patentansprüche

1. HF-Empfangsspulenanordnung für insbesondere hochauflösende Kernspinresonanz-Spektrometer mit mindestens einem ersten aus supraleitendem Material aufgebauten HF-Empfangsspulensystem (4a, 4b; 14a, 14b) zum Empfangen von Kernspinresonanzsignalen, das um eine normalerweise ungefähr auf Zimmertemperatur in einem homogenen Magnetfeld befindliche Probe (1) angeordnet ist und das aus mindestens einer symmetrisch um die Probe (1) angeordneten Einzelspule besteht, wobei das erste HF-Empfangsspulensystem (4a, 4b; 14a, 14b) zumindest teilweise auf eine weit unter Zimmertemperatur liegende kryogene Betriebstemperatur gekühlt ist, bei der sich das erste HF-Empfangsspulensystem (4a, 4b; 14a, 14b) in supraleitendem Zustand befindet,
dadurch gekennzeichnet,
daß mindestens ein zweites HF-Empfangsspulensystem (3a, 3b; 13a, 13b) vorgesehen ist, das vorzugsweise zum ersten HF-Empfangsspulensystem (4a, 4b; 14a, 14b) orthogonal ist, wobei das zweite HF-Empfangsspulensystem (3a, 3b; 13a, 13b) ebenfalls aus mindestens einer symmetrisch um die Probe (1) angeordneten Einzelspule besteht, und wobei das erste und das zweite HF-Empfangsspulensystem unterschiedliche radiale Abstände von der Probe (1) aufweisen, und daß das zweite innere HF-Empfangsspulensystem (3a, 3b; 13a, 13b) aus elektrisch resistivem Material aufgebaut ist, wobei die Materialien und die Geometrien der HF-Empfangsspulensysteme so gewählt sind, daß der von sämtlichen HF-Empfangsspulen der Anordnung resultierende Einfluß der Suszeptibilität der HF-Empfangsspulenanordnung bei der kryogenen Betriebstemperatur des supraleitenden HF-Empfangsspulensystems (4a, 4b; 14a, 14b) auf die Homogenität des Magnetfeldes im Bereich der Probe (1) minimal ist.

2. HF-Empfangsspulenanordnung nach Anspruch 1, dadurch gekennzeichnet, daß zumindest das innere HF-Empfangsspulensystem (3a, 3b; 13a, 13b) eine derartige Struktur aufweist, daß seine Gesamtsuszeptibilität nach außen hin im Sinne einer Reduzierung der Suszeptibilitäts-Inhomogenitäten im Bereich der Probe außerhalb des Empfangsspulensystems kompensiert ist.

3. HF-Empfangsspulenanordnung nach Anspruch 2, dadurch gekennzeichnet, daß das innere HF-Empfangsspulensystem (3a, 3b; 13a, 13b) aus suszeptibilitätskompensiertem Kupferdraht mit Platinseele aufgebaut ist.

4. HF-Empfangsspulenanordnung nach einem der vorhergehenden Ansprüche, dadurch gekennzeichnet, daß mindestens ein supraleitendes HF-Empfangsspulensystem vorgesehen ist, bei dem die Spulen aus einer auf ein Substrat aufgebrachten, zwischen einem und zehn Mikrometer dicken Schicht bestehen.

5. HF-Empfangsspulenanordnung nach Anspruch 4, dadurch gekennzeichnet, daß das Substrat aus Saphir oder Quarz besteht.

6. HF-Empfangsspulenanordnung nach Anspruch 4, dadurch gekennzeichnet, daß das Substrat zusammen mit einem damit in wärmeleitendem Kontakt stehenden Metallblock, insbesondere aus Kupfer oder Aluminium, eine gekühlte Plattform bildet.

7. HF-Empfangsspulenanordnung nach einem der vorhergehenden Ansprüche, dadurch gekennzeichnet, daß zumindest ein Teil der HF-Empfangsspulen indirekt gekühlt ist.

8. HF-Empfangsspulenanordnung nach Anspruch 7, dadurch gekennzeichnet, daß der andere Teil der HF-Empfangsspulen direkt gekühlt ist.

9. HF-Empfangsspulenanordnung nach einem der vorhergehenden Ansprüche, dadurch gekennzeichnet, daß die HF-Empfangsspulensysteme (3a, 3b, 4a, 4b) im Bereich um die Probe im Vakuum (6) angeordnet sind.

## Claims

1. RF receiver coil system, in particular, for high resolution nuclear magnetic resonance spectrometers having at least a first RF receiver coil system (4a,4b;14a,14b), made from superconducting material, for receiving nuclear magnetic resonance signals which is arranged about a normally approximately room temperature sample (1) located in a homogeneous magnetic field and consists of at least one individual coil disposed symmetrically about the sample (1), the first RF receiver coil system (4a,4b;14a,14b) being at least partially cooled to a cryogenic operating temperature far below room temperature at which the first RF receiver coil system (4a,4b;14a,14b) is in the superconducting state
characterized in that
at least a second RF receiver coil system (3a, 3b; 13a, 13b) is provided which is preferably orthogonal to the first RF receiver coil system (4a,4b;14a,14b), wherein the second RF receiver coil system (3a,3b; 13a,13b) also consists of at least one individual coil symmetrically arranged about the sample (1), the first and second RF receiver coil systems having different radial separations from the sample (1) and the second inner RF receiver coil system (3a, 3b; 13a, 13b) is made from an electrically resistive material, the materials and the geometries of the RF receiver coil systems being chosen to minimize the influence of the susceptibility of the RF receiver coil system resulting from all RF receiver coils of the configuration at the cryogenic operating temperature of the superconducting RF receiver coil system (4a,4b;14a,14b) on the homogeneity of the magnetic field in the vicinity of the sample (1).

2. RF receiver coil system according to claim 1, characterized in that at least the inner RF receiver coil system (3a, 3b; 13a, 13b) has a structure which compensates its entire external susceptibility in the sense of a reduction of the susceptibility inhomogeneities in the region of the sample outside of the receiver coil system.

3. RF receiver coil system according to claim 2, characterized in that the inner RF receiver coil system (3a, 3b; 13a, 13b) is constructed from susceptibility compensated copper wire with a platinum core.

4. RF receiver coil system according to any one of the preceding claims, characterized in that at least one superconducting RF receiver coil system is provided for having coils comprising a layer in the order of one to ten microns in thickness applied onto a substrate.

5. RF receiver coil system according to claim 4, characterized in that the substrate consists of sapphire or quartz.

6. RF receiver coil system according to claim 4, characterized in that the substrate forms a cooled platform together with a metal block which is in heat conducting contact therewith and, in particular, made from copper or aluminum.

7. RF receiver coil system according to any one of the preceding claims, characterized in that at least one part of the RF receiver coils is indirectly cooled.

8. RF receiver coil system according to claim 7, characterized in that the other part of the RF receiver coils is directly cooled.

9. RF receiver coil system according to any one of the preceding claims, characterized in that the RF receiver coil systems (3a, 3b, 4a, 4b) are arranged in vacuum (6) about the sample.

## Revendications

1. Dispositif de bobines de réception HF pour spectromètres à résonance magnétique nucléaire notamment dotés d'une haute résolution, présentant au moins un premier système à bobines de réception HF (4a, 4b ; 14a, 14b) qui est constitué d'un matériau supraconducteur en vue de recevoir des signaux de résonance magnétique nucléaire, est disposé autour d'une éprouvette (1) située dans un champ magnétique homogène, normalement à peu près à température ambiante, et consiste en au moins une bobine individuelle agencée symétriquement autour de l'éprouvette (1), le premier système à bobines de réception HF (4a, 4b ; 14a, 14b) étant refroidi, au moins partiellement, jusqu'à une température cryogène de fonctionnement largement inférieure à la température ambiante, et en présence de laquelle le premier système à bobines de réception HF (4a, 4b ; 14a, 14b) se trouve à l'état supraconducteur,
caractérisé par le fait
qu'il est prévu au moins un second système à bobines de réception HF (3a, 3b ; 13a, 13b), préférentiellement orthogonal par rapport au premier système à bobines de réception HF (4a, 4b ; 14a, 14b), le second système à bobines de réception HF (3a, 3b ; 13a, 13b) consistant semblablement en au moins une bobine individuelle agencée symétriquement autour de l'éprouvette (1), et les premier et second systèmes à bobines de réception HF étant espacés de distances radiales différentes vis-à-vis de l'éprouvette (1) ; et par le fait que le second système intérieur à bobines de réception HF (3a, 3b ; 13a, 13b) est constitué d'un matériau électriquement résistif, les matériaux et les géométries des systèmes à bobines de réception HF étant choisis de façon telle que l'influence de la susceptibilité du dispositif de bobines de réception HF à la température cryogène de fonctionnement du système supraconducteur à bobines de réception HF (4a, 4b ; 14a, 14b), résultant de toutes les bobines de réception HF de l'ensemble, soit minimale sur l'homogénéité du champ magnétique dans la région de l'éprouvette (1).

2. Dispositif de bobines de réception HF selon la revendication 1, caractérisé par le fait qu'au moins le système intérieur à bobines de réception HF (3a, 3b ; 13a, 13b) présente une structure telle que sa susceptibilité globale est compensée vers l'extérieur, dans le sens d'une réduction de la non-homogénéité de la susceptibilité dans la région de l'éprouvette, en dehors du système à bobines de réception HF.

3. Dispositif de bobines de réception HF selon la revendication 2, caractérisé par le fait que le système intérieur à bobines de réception HF (3a, 3b ; 13a, 13b) est constitué d'un fil de cuivre à âme de platine, dont la susceptibilité est compensée.

4. Dispositif de bobines de réception HF selon l'une des revendications précédentes, caractérisé par le fait qu'il est prévu au moins un système supraconducteur à bobines de réception HF, dans lequel les bobines sont constituées d'une couche d'une épaisseur comprise entre un et dix micromètres, déposée sur un substrat.

5. Dispositif de bobines de réception HF selon la revendication 4, caractérisé par le fait que le substrat consiste en du saphir ou en du quartz.

6. Dispositif de bobines de réception HF selon la revendication 4, caractérisé par le fait que le substrat forme une platine refroidie en coopérant avec un bloc métallique, notamment en cuivre ou en aluminium, en contact thermiquement conducteur avec ledit substrat.

7. Dispositif de bobines de réception HF selon l'une des revendications précédentes, caractérisé par le fait qu'au moins une partie des bobines de réception HF est refroidie indirectement.

8. Dispositif de bobines de réception HF selon la revendication 7, caractérisé par le fait que l'autre partie des bobines de réception HF est refroidie directement.

9. Dispositif de bobines de réception HF selon l'une des revendications précédentes, caractérisé par le fait que les systèmes à bobines de réception HF (3a, 3b, 4a, 4b) sont disposés, dans la région entourant l'éprouvette, dans un espace (6) dans lequel un vide est créé.
